# EUROPEAN PATENT APPLICATION

(11) **EP 4 404 400 A2**
(43) Date of publication of application: **24.07.2024**
(21) Application number: 24152456.0
(22) Date of filing: 17.01.2024
(51) Int. Cl.: H01S 5/028, H01S 5/30, H01S 5/065, H01S 5/323, H01S 5/00, H01S 5/024, H01S 5/40

(54) **MULTI-JUNCTION LASER DIODE WITH IMPROVED WAVELENGTH STABILITY**

(30) Priority: 18.01.2023 US 202363480353 P; 08.01.2024 US 202418406480
(71) Applicant: II-VI Delaware, Inc., Wilmington, DE 19890 (US)
(72) Inventor: STAUDINGER, Philipp, Wilmington, 19890 (US); EBERHARD, Franz, Wilmington, 19890 (US); MÜLLER, Jürgen, Wilmington, 19890 (US)
(74) Representative: Schmidt, Christian

(57) **Abstract**

This disclosure describes a multi-junction laser diode with improved wavelength stability. The multi-junction laser diode is found in an edge emitting laser (EEL). The disclosed system and method are suited for improving the wavelength stability of multi-junction EEL without coupling the laser modes of the individual junctions and without using any external elements such as Fiber Bragg Gratings (FBR), Volume Bragg Gratings (VBG) or Thermoelectric Cooling (TEC).

## Description

### CROSS REFERENCE TO RELATED APPLICATIONS

This application claims the benefit of and priority to U.S. Provisional Patent Application No. 63/480,353, titled "MULTI-JUNCTION LASER DIODE WITH IMPROVED WAVELENGTH STABILITY," filed January 18, 2023, the disclosure of which is incorporated herein by reference in its entirety.

### BACKGROUND

Limitations and disadvantages of traditional multi-junction laser diodes will become apparent to one of skill in the art, through comparison of such approaches with some aspects of the present method and system set forth in the remainder of this disclosure with reference to the drawings.

### BRIEF SUMMARY

Systems and methods are provided for producing a multi-junction laser diode with improved wavelength stability, substantially as illustrated by and/or described in connection with at least one of the figures, as set forth more completely in the claims.

### BRIEF DESCRIPTION OF THE DRAWINGS

FIG. 1 illustrates an example Illustration of an edge emitting laser (EEL) for LiDAR applications with typical chip dimensions of 400x600 µm², in accordance with various example implementations of this disclosure.
FIG. 2 illustrates an example cross-sectional sketch of the multi-junction laser with improved wavelength stability, in accordance with various example implementations of this disclosure.
FIG. 3 illustrates an example of reflectivity of a standard front mirror as reference with weak wavelength dependency and a wavelength-stabilizing mirror with strong wavelength dependency, in accordance with various example implementations of this disclosure.
FIG. 4 illustrates an example emission spectra for different heatsink temperatures of a GaAs based multi-junction laser with a standard mirror (left) and a wavelength-stabilizing mirror (right), in accordance with various example implementations of this disclosure.
FIG. 5a illustrates an example spectral shift vs. temperature for a standard chip and a chip with λ-stabilization, in which the wavelength shift reduces from more than 30 nm to around 5 nm in the plotted temperature range which on average is less than 0.04 nm/K and between 5°C and 105°C only around 2 nm wavelength shift is recorded, in accordance with various example implementations of this disclosure.
FIG. 5b illustrates an example power over temperature performance under pulsed operation of 100 ns and 0.1 % d.c. is similar for both chips but slightly higher at low T and lower at high T for the λ-stabilized chip, in accordance with various example implementations of this disclosure.

### DETAILED DESCRIPTION

High power lasers generating ns-pulses are key components for LiDAR systems, providing fast, reliable, and far-range 3D depth information. A variety of applications exist based on this technology - from rangefinders over industrial sensing to autonomous guidance systems for self-driving cars and robots. Each of these applications has its own specific set of requirements and therefore LiDAR comes in many different forms. The most mature technology is direct time-of-flight (dToF). Such systems essentially measure the time delay of a reflected short pulse to extract spatially resolved distance information. They come in two variations. Flash systems illuminate the entire scene at once, while scanning systems use complex optics to scan a laser across the field of view. These systems may comprise Edge Emitting Lasers (EEL). EEL exhibit superior brightness, which makes them the ideal technology for the use in long range scanning dTOF LiDAR systems.

EEL may be fabricated on GaAs at Near Infrared (NIR) wavelengths ranging from 800 to 1100 nm. Different applications require different choices for the wavelength that is being used. 905 nm is superior when it comes to detecting obstacles through rain and fog and enable higher quantum efficiency at the detector side. This disclosure presents EEL with 905 nm wavelength. However, EEL with any wavelength is also possible.

To filter out the remaining sunlight background, it is important to use a narrow spectral bandwidth filter at the detector side. The main limitation on the type of filter that can be used for EEL presents the large wavelength shift which follows the gain shift of the material system - in case of GaAs -0.3 nm/K. The smaller the bandpass wavelength window the better the laser signal to sunlight background noise becomes. Wavelength stabilization is therefore key to further improve the detection range of LiDAR systems. This disclosure presents wavelength stabilized EEL chips that reduce the spectral shift by a factor of 6 in the range between -35°C and 105° to an average of <0.04 nm/K.

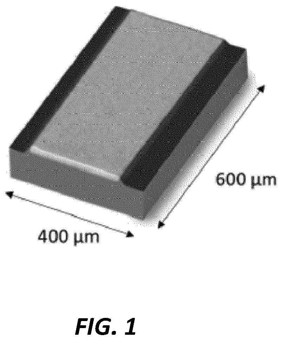

This disclosure presents lasers with any number of tunnel junctions. For example, 3 junctions connected by 2 tunnel junctions, or 4 junctions connected by 3 tunnel junctions. The example EEL operates at 905 nm and has a footprint of 400x600 µm². FIG. 1 illustrates an example Illustration of an edge emitting laser (EEL) for LiDAR applications with chip dimensions of 400x600 µm², in accordance with various example implementations of this disclosure. The emitting area in this example may be 200×10 µm² or 200x13 µm² depending on the number of junctions. However, this disclosure is not limited by a specific number of junctions or by a specific size of the emitting area.

To achieve a stable wavelength behavior without changing the gain material, a laser needs to be designed in a way that the mode does not solely follow the gain shift but is dominated by the resonator itself, similar to a VCSEL structure. Conventionally, distributed Bragg reflector (DBR) and distributed-feedback (DFB) lasers have been utilized to internally stabilize the wavelength shift in EEL. In multi-junction devices the situation is more complicated. Each of the junctions may operate as an individual laser without any mode coupling. Control of the laser cavity via surface gratings can therefore only affect the uppermost laser and is thus not a viable option to stabilize the wavelength of the entire device. Different laser designs can address this limitation, but at the cost of using higher-order vertical modes, which generally lead to non-standard far-field characteristics which can be challenging for integrating the laser into a system using conventional optics.

This disclosure describes a technology that is suited for improving the wavelength stability of multi-junction EEL without coupling the laser modes of the individual junctions and without using any external elements such as Fiber Bragg Gratings (FBR), Volume Bragg Gratings (VBG) or Thermoelectric Cooling (TEC). For persons skilled in the art, it is also obvious that the disclosure works for single-junction EEL where conventional stabilization methods are also applicable as well as for designs using higher order or coupled waveguides and modes.

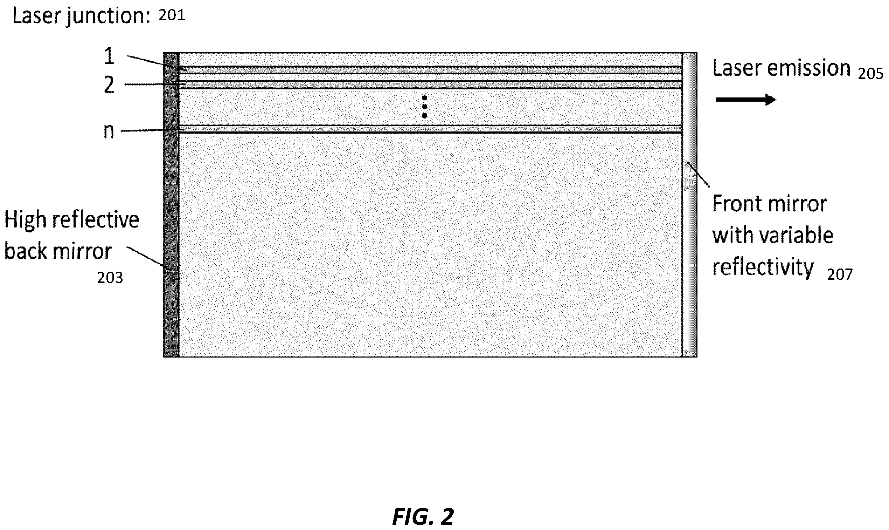

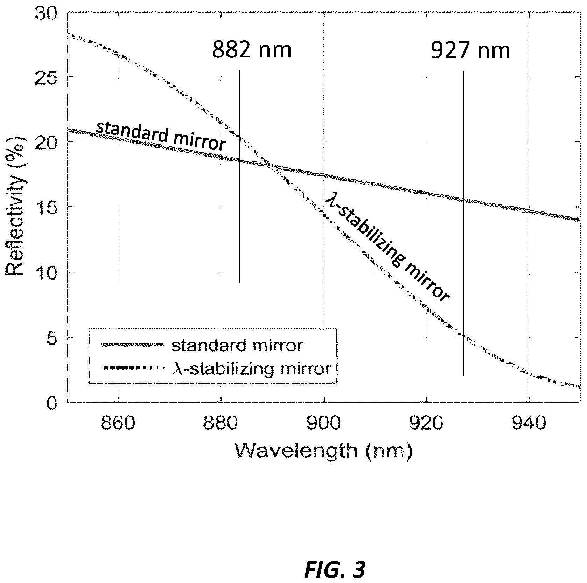

FIG. 2 illustrates an example cross-sectional sketch of the multi-junction laser with improved wavelength stability, in accordance with various example implementations of this disclosure. The EEL consists of a laser cavity comprising multiple lasing junctions 201, a high reflective back mirror 203 deposited on a first facet as well as a front mirror deposited on a second facet but with variable reflectivity over wavelength. The n lasing junctions 201 are electrically connected in series by means of tunnel junctions. The laser emission 205 occurs at the second facet that comprises a front mirror 207 with variable reflectivity as described further with respect to FIG. 3.

FIG. 3 illustrates an example of reflectivity of a standard front mirror as reference with weak wavelength dependency and a wavelength-stabilizing front mirror (e.g., front mirror 207 of FIG. 2) with strong wavelength dependency, in accordance with various example implementations of this disclosure. The front mirror (e.g., front mirror 207 of FIG. 2) is designed such that the reflectivity of the front mirror decreases rapidly with increasing wavelength as shown in FIG. 3 and within the wavelength region where the laser medium provides gain. The slope of the reflectivity of the wavelength-stabilizing front mirror (e.g., front mirror 207 of FIG. 2) differentiates the wavelength-stabilizing front mirror over standard mirrors. For example, over an interval that extends from 2% below an emission wavelength to 3% above the emission wavelength, a wavelength-stabilizing mirror may have a maximum of the reflectivity that is more than two times a minimum of the reflectivity. FIG. 3 illustrates an example wavelength-stabilizing mirror with an emission wavelength of 900 nm. Over an interval that extends from 882 nm to 927 nm, this example wavelength-stabilizing mirror has a maximum reflectivity of 20% and a minimum reflectivity of 5%.

A wavelength-stabilizing mirror can be achieved by either single or multilayer dielectric coatings. In the example presented in the following, an AlOx coating deposited with ion beam sputtering with a thickness of around 1000 nm is used to stabilize the wavelength at around 900 nm. But also, other coating materials and thicknesses are suitable as long as they exhibit a falling reflectivity at longer wavelengths with sufficient incline (for example 750 nm or 1300 nm AIOx for a wavelength of 900 nm).

Lasing generally is achieved through feedback generated in a resonator, which may be formed by the dielectric mirrors on the front and back facet. The larger the feedback (i.e. the reflectivity), the easier the lasing condition is met. If the reflectivity is not constant across competing lasing modes with different wavelengths, it is therefore possible to reduce the lasing condition for some of the modes (i.e. make them lase more easily) and increase the lasing condition for others. In the case of the mirrors presented in FIG. 3, modes with wavelength smaller than 885 nm will start lasing easier with the wavelength-stabilizing mirror than with the standard mirror and vice versa for modes with longer wavelength. As the gain of the active material shifts to longer wavelengths at higher temperature this effect can therefore be counterbalanced by introducing such a mirror that favors modes with lower wavelength. Applying the mirror at the front facet rather than on the back facet helps to reduce lasing from the back facet and resulting reduced efficiency of the laser diode. The threshold current is increased at larger wavelengths when applying such a stabilization. Therefore, this technology is particularly suited for lasers with an operation point well above the threshold current (e.g. 30x to 50x) to reduce the relative power penalty.

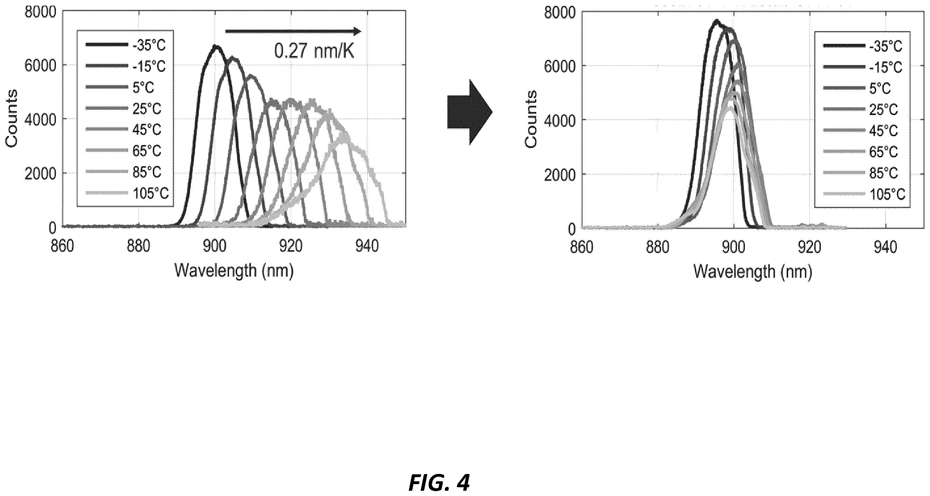

FIG. 4 illustrates an example emission spectra for different heatsink temperatures of a GaAs based multi-junction laser with a standard mirror (left) and a wavelength-stabilizing mirror (right), in accordance with various example implementations of this disclosure. FIG. 4 indicates experimental results obtained using the disclosed technology. Two multi-junction laser diodes of otherwise same design are coated with a conventional standard front mirror coating and a wavelength stabilizing front mirror coating, respectively. Their emission spectra are recorded for several temperatures of the heatsink from -35°C to 105°C. The emission of the laser with standard mirror (left) shifts (and broadens) according to the gain shift in the GaAs system by around 0.27 nm/K. Instead, the laser with wavelength-stabilizing mirror changes the wavelength only up to around 900 nm after which it remains comparatively stable.

The reason is that, at a larger wavelength, the low reflectivity prohibits the laser from lasing efficiently and modes at lower wavelength, even considering that they are not located at the gain maximum, are preferred. An average wavelength shift between 35°C and 105°C of less than 0.04 nm/K is recorded. Further, as the lasing modes are restricted, the typical broadening at higher temperatures is not observed and the spectral width remains nearly constant.

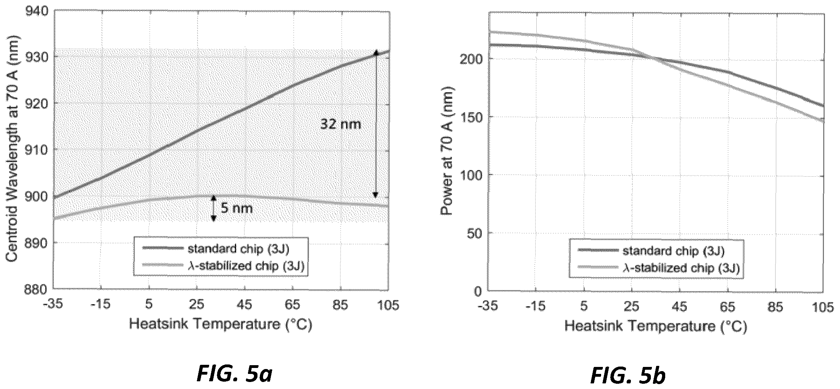

FIG. 5a illustrates an example spectral shift vs. temperature for a standard chip and a chip with λ-stabilization, in which the wavelength shift reduces from more than 30 nm to around 5 nm in the plotted temperature range which on average is less than 0.04 nm/K and between 5°C and 105°C only around 2 nm wavelength shift is recorded, in accordance with various example implementations of this disclosure. While EEL can deliver high output powers at very high brightness, their weakness is the comparably large wavelength shift conventionally following the gain shift in the GaAs system of around 0.3 nm/K. This behavior can be observed in FIG. 5a, it is very similar for all EEL presented so far. Such a wavelength shift is detrimental for building LiDAR systems, because it limits the spectral width that can be used on the detector side and therefore also the reachable signal-to-noise ratio.

This disclosure develops a new EEL chip design that stabilizes the wavelength over a large temperature range. FIG. 5a shows the wavelength shift of a conventional laser as reference and an equivalent laser with λ-stabilization. While the spectrum of the standard laser shifts at constant rate across the entire measured temperature window, the novel design enables a remarkably stable operation. From - 35°C to 105°C a spectral window of only 5 nm is utilized which is a factor of 6 less than the reference and corresponds to an average wavelength shift of less than 0.04 nm/K.

At the same time the power remains nearly as stable as for the standard chip as indicated in FIG. 5b. FIG. 5b illustrates an example power over temperature performance under pulsed operation of 100 ns and 0.1% duty cycle is similar for both chips but slightly higher at low T and lower at high T for the λ-stabilized chip, in accordance with various example implementations of this disclosure. A λ-stabilized chip as presented in this disclosure enables the usage of much narrower bandpass filters at the detector side and is therefore ideal for improving the signal-to-noise-ratio and thus the detection range of dTOF LiDAR systems.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A system, the system comprising:
a laser diode comprising:
a laser cavity comprising one or more lasing junctions;
a first mirror on a first facet of the laser cavity; and
a second mirror on a second facet of the laser cavity, wherein a reflectivity of at least one of the first mirror and the second mirror is variable over wavelength.

2. The system of claim 1, wherein the system comprises an edge emitting laser (EEL).

3. The system of claim 2, wherein the first facet is the back or high reflecting facet of the EEL and the second facet is the front or emitting facet of the EEL.

4. The system of claim 2, wherein the first facet is the front or emitting facet of the EEL and the second facet is the back or high reflecting facet of the EEL.

5. The system of claim 1, wherein:
the one or more lasing junctions comprise a plurality of lasing junctions, and
the plurality of lasing junctions are electrically connected in series via one or more tunnel junctions.

6. The system of claim 1, wherein the system comprises a plurality of laser diodes on a chip.

7. The system of claim 1, wherein one or both of the first mirror and the second mirror comprises a plurality of dielectric layer coatings.

8. The system of claim 1, wherein the second mirror comprises an AlOx coating.

9. The system of claim 1, wherein the second mirror comprises a dielectric coating that is greater than 1 micron.

10. The system of claim 1, wherein:
a maximum of the reflectivity in an interval is more than two times a minimum of the reflectivity in the interval, and
the interval extends from 2% below an emission wavelength to 3% above the emission wavelength.

11. A method, the method comprising:
forming a laser cavity via one or more lasing junctions;
depositing a first mirror on a first facet of the laser cavity;
depositing a second mirror on a second facet, wherein a reflectivity of at least one of the first mirror and the second mirror is variable over wavelength; and
generating a feedback, in the laser cavity, between the first mirror and the second mirror.

12. The method of claim 11, wherein the method comprises fabricating an edge emitting laser (EEL).

13. The method of claim 12, wherein the first facet is the back or high reflecting facet of the EEL and the second facet is the front or emitting facet of the EEL.

14. The method of claim 12, wherein the first facet is the front or emitting facet of the EEL and the second facet is the back or high reflecting facet of the EEL.

15. The method of claim 11, wherein the one or more lasing junctions comprises a plurality of lasing junctions, and the method comprises electrically connecting the plurality of lasing junctions in series via one or more tunnel junctions.

16. The method of claim 11, wherein one or both of the first mirror and the second mirror comprises a plurality of dielectric layer coatings.

17. The method of claim 11, wherein depositing the second mirror comprises ion beam sputtering an AlOx coating.

18. The method of claim 11, wherein the second mirror comprises a dielectric coating that is greater than 1 micron.

19. The method of claim 11, wherein:
a maximum of the reflectivity in an interval is more than two times a minimum of the reflectivity in the interval, and
the interval extends from 2% below an emission wavelength to 3% above the emission wavelength.
